# EUROPEAN PATENT APPLICATION

(11) **EP 2 538 451 A1**
(43) Date of publication of application: **26.12.2012**
(21) Application number: 11742196.6
(22) Date of filing: 07.02.2011
(51) Int. Cl.: H01L 31/042

(54) **MANUFACTURING METHOD FOR THIN-FILM SOLAR CELL MODULE**

(30) Priority: 15.02.2010 JP 2010030063
(71) Applicant: Sony Chemical & Information Device Corporation, Tokyo 141-0032 (JP)
(72) Inventor: NISHIMOTO Masahiro, Kanuma-shi Tochigi 322-8502 (JP); UCHIMI Toshiharu, Kanuma-shi Tochigi 322-8502 (JP)
(74) Representative: Ehlich, Hendrik
(86) International application number: PCT/JP2011/052535
(87) International publication number: WO 2011/099452

(57) **Abstract**

When a solar cell module is manufactured by resin-sealing a solar cell having a surface electrode to which a tab wire is connected, a tab wire connection step of connecting a tab wire to the surface electrode and a resin sealing step of sealing the solar cell with a sealing resin is made possible to be performed at a time at a relative low temperature of the resin sealing step. It is also intended to prevent production of voids in thermocompression areas. For such purposes, a thin-film solar cell having a surface electrode to which a tab wire is connected is resin-sealed with a conductive adhesive film by using a decompression laminator, whereby the thin-film solar cell module is manufactured. A decompression laminator having a first chamber and a second chamber partitioned by a flexible sheet is used. Each chamber is capable of independent internal pressure adjustment. The second chamber includes a heating stage capable of heating. A resin mutually compatible with the thermoplastic resin constituting the conductive adhesive film is used as the sealing resin.

## Description

### Technical Field

The present invention relates to a method of manufacturing a thin-film solar cell module that has a structure such that a thin-film solar cell having a surface electrode to which a tab wire is connected is resin-sealed with a sealing resin.

### Background Art

As a method of manufacturing a thin-film solar cell module, one that includes performing a resin sealing step using a vacuum laminating machine having a flexible diaphragm as one of its components has been known (Patent Literature 1). In such a manufacturing method, a thin-film solar cell having a surface electrode to which a tab wire is soldered is placed on a heating plate of the machine body of the vacuum laminator. A polyethylene-vinyl acetate copolymer resin (EVA resin) sheet is further placed thereon as a sealing resin via a back sheet. The diaphragm is then put over the machine body. While heating the thin-film solar cell by the heating plate, the interior of the machine body is decompressed so that the diaphragm presses the EVA resin to perform thermocompression processing for resin sealing. The resin sealing step is performed in such a manner.

### Citation List

### Patent Literature

[Patent Literature 1] JP2004-311571A

### Summary of the Invention

### Problem(s) to be Solved by the Invention

According to the technology of Patent Document 1, however, a tab wire connection step of soldering a copper tab wire that is solder-coated in advance onto a surface electrode of a thin-film solar cell at a temperature of approximately 240°C and the resin sealing step of performing resin sealing using EVA resin at a temperature of approximately 150°C are separately performed due to the different process temperatures. This lengthens manufacturing cycles and increase the number of times of handling, resulting in a problem of increased manufacturing costs.

The vacuum laminator used in the technology of Patent Document 1 has its diaphragm opened to the air outside the machine all the time. When the interior of the machine is brought into a decompressed state, the diaphragm therefore immediately presses the heated thin-film solar cell and the sheet-like sealing resin inside the machine body. As a result, insufficient degassing between the layers may produce voids in the thermocompression areas.

The present invention has been achieved in order to solve the foregoing conventional problem. An object thereof is to make, when manufacturing a solar cell module by resin-sealing a solar cell having a surface electrode to which a tab wire is connected, a tab wire connection step of connecting a tab wire to the surface electrode and a resin sealing step of sealing the solar cell with a sealing resin possible to be performed at a time at a relative low temperature of the resin sealing step, and to prevent the production of voids in thermocompression areas.

### Means for Solving the Problem(s) by the Invention

The inventors have found that the connection of a tab wire to an electrode of a solar cell and the resin sealing of the solar cell can be performed at a time at a relatively low temperature during the resin sealing of the solar cell if the tab wire is bonded to the surface electrode of the thin-film solar cell with a conductive adhesive film made of a thermoplastic resin in which conductive particles are dispersed, and a resin compatible with the thermoplastic resin is used as a sealing resin. The inventors have also found that the machine body can be divided into two chambers capable of independent internal pressure adjustment so that the diaphragm of the vacuum laminator may not immediately press a thin-film solar cell and the like inside the machine body when the machine body is brought into a decompressed state, thereby completing the present invention.

That is, the present invention provides a method of manufacturing a thin-film solar cell module by using a decompression laminator, the thin-film solar cell module having a structure such that a thin-film solar cell having a surface electrode to which a tab wire is connected with a conductive adhesive film is resin-sealed with a sealing resin, the conductive adhesive film being made of a thermoplastic resin in which conductive particles are dispersed, the method including:
using, as the sealing resin, a resin mutually compatible with the thermoplastic resin constituting the conductive adhesive film;
using a decompression laminator having a first chamber and a second chamber partitioned by a flexible sheet, the first and second chambers each being capable of independent internal pressure adjustment, the second chamber including a heating stage capable of heating;
placing a solar cell having a surface electrode upon the heating stage of the second chamber of the decompression laminator, arranging the conductive adhesive film and the tab wire on the surface electrode in succession, further arranging a sheet-like sealing resin so as to cover the entire solar cell, and arranging a moisture-proof back sheet or glass plate thereon; and
making the internal pressure of the first chamber of the decompression laminator relatively higher than that of the second chamber so that the flexible sheet presses the moisture-proof back sheet or glass plate while the heating stage heats the solar cell, whereby the surface electrode of the thin-film solar cell and the tab wire are connected with the conductive adhesive film and the thin-film solar cell is resin-sealed with the sealing resin to obtain a solar cell module.

### Advantageous Effects of the Invention

According to the method of manufacturing a solar cell module of the present invention, the conductive adhesive film made of the thermoplastic resin in which conductive particles are dispersed is used to connect the tab wire and the surface electrode of the thin-film solar cell, at which time the thermoplastic resin of the conductive adhesive film and the sealing resin melt together. The tab wire connecting step and the resin sealing step can thus be performed at a time at a relatively low process temperature of the resin sealing step. In addition, connection strength more than from the width of the tab wire can be obtained, and sealing power improves as well. This improves the long-term reliability of solar cell characteristics.

According to the method of manufacturing a solar cell module of the present invention, the vacuum laminator is divided into two chambers that are capable of independent internal pressure adjustment. Since both the chambers can be simultaneously brought into a decompressed state, the flexible sheet can be prevented from immediately pressing the thin-film solar cell and the like inside the machine body.

### Brief Description of the Drawings

Fig. 1 is a schematic sectional view of a decompression laminator.
Fig. 2A is an explanatory diagram showing the use of the decompression laminator.
Fig. 2B is an explanatory diagram showing the use of the decompression laminator.
Fig. 2C is an explanatory diagram showing the use of the decompression laminator.
Fig. 2D is an explanatory diagram showing the use of the decompression laminator.
Fig. 2E is an explanatory diagram showing the use of the decompression laminator.
Fig. 3A is a diagram showing a step of a manufacturing method according to the present invention.
Fig. 3B is a diagram showing a step of the manufacturing method according to the present invention.
Fig. 3C is a schematic sectional view of a thin-film solar cell module manufactured by the manufacturing method according to the present invention.
Fig. 4 is a schematic top view of the thin-film solar cell module.
Fig. 5 is a temperature-viscosity characteristic chart of conductive adhesive films according to Reference Examples 4 and 5.

### Embodiments for Carrying out the Invention

A manufacturing method according to the present invention is a method of manufacturing a thin-film solar cell module by using a decompression laminator, the thin-film solar cell module having a structure such that a thin-film solar cell having a surface electrode to which a tab wire is connected with a conductive adhesive film is resin-sealed with a sealing resin, the conductive adhesive film being made of a thermoplastic resin in which conductive particles are dispersed.

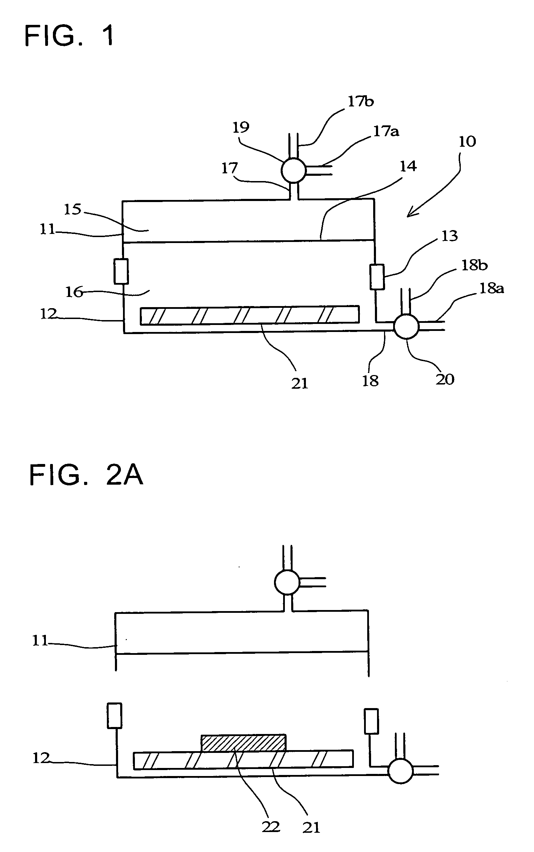

The decompression laminator used in the present invention has a first chamber and a second chamber partitioned by a flexible sheet. Each chamber is capable of independent internal pressure adjustment. The second chamber includes a heating stage which is capable of heating. An example of such a decompression laminator will be described in more detail with reference to Fig. 1.

Fig. 1 shows a decompression laminator 10 before use. The decompression laminator 10 is composed of an upper unit 11 and a lower unit 12. These units are separably integrated via a seal member 13 such as an O ring. The upper unit 11 is provided with a flexible sheet 14 of silicone rubber or the like. The flexible sheet 14 partitions the decompression laminator 10 into a first chamber 15 and a second chamber 16. A thin glass cloth-reinforced Teflon (TM) sheet may be arranged on the surface of the flexible sheet 14 on the side of the second chamber 16 in order to prevent adhesion of a molten sealing resin such as EVA.

The upper unit 11 and the lower unit 12 are equipped with piping 17 and 18, respectively, so that the chambers can be independently adjusted in internal pressure, i.e., decompressed, compressed, and even opened to the air by means of a vacuum pump, a compressor, etc. The piping 17 is branched into two directions, 17a and 17b, by a changeover valve 19. The piping 18 is branched into two directions, 18a and 18b, by a changeover valve 20. The lower unit 12 includes a stage 21 which is capable of heating.
Such a decompression laminator 10 is used, for example, as shown in Figs. 2A to 2E.
Initially, as shown in Fig. 2A, the upper unit 11 and the lower unit 12 are separated. A laminate 22 to be processed by thermocompression is placed on the stage 21.

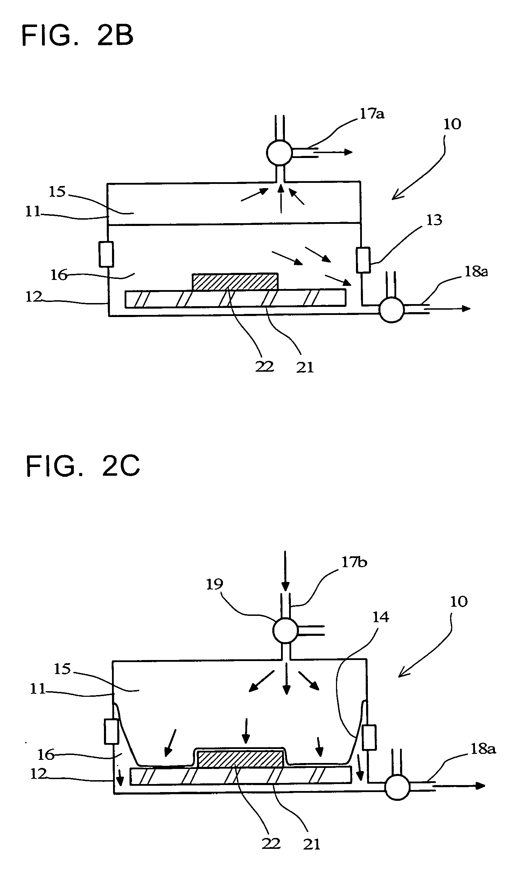

Next, as shown in Fig. 2B, the upper unit 11 and the lower unit 12 are separably integrated via the seal member 13. Vacuum pumps (not shown) are then connected to the piping 17a and 18a, respectively, and the interiors of the first chamber 15 and the second chamber 16 are made high vacuum.

As shown in Fig. 2C, with the interior of the second chamber 16 maintained high vacuum, the changeover valve 19 is switched to let air into the first chamber 15 through the piping 17b. The flexible sheet 14 is thereby spread out toward the second chamber 16. As a result, the laminate 22 is pressed by the flexible sheet 14 while heated by the stage 21.

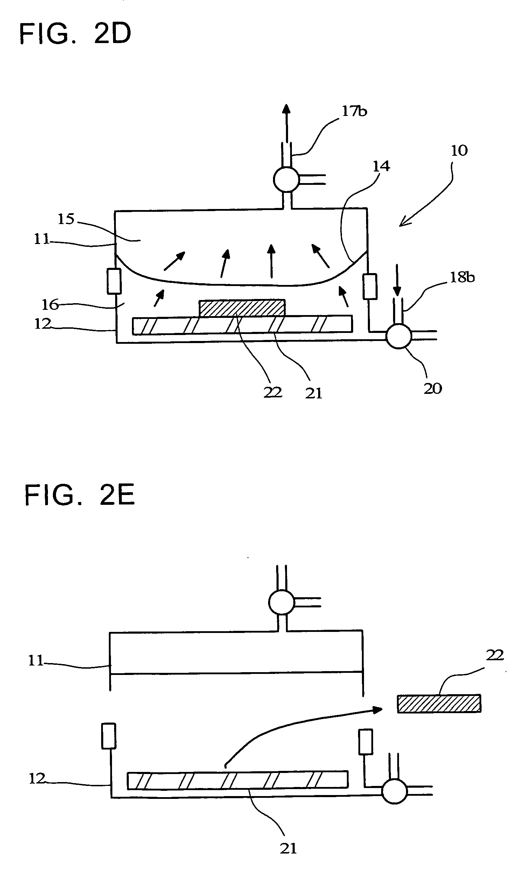

Next, as shown in Fig. 2D, the changeover valve 20 is switched to let air into the second chamber 16 through the piping 18b. The flexible sheet 14 is thereby pushed back toward the first chamber 15 until the first chamber 15 and the second chamber 16 have the same internal pressure.

Finally, as shown in Fig. 2E, the upper unit 11 and the lower unit 12 are separated and the laminate 22 processed by thermocompression is unloaded from the stage 21. This completes the operation cycle of the decompression laminator 10. The operation then returns to Fig. 2A.

As will be described later, according to the present invention, the laminate 22 is basically a laminate that includes a thin-film solar cell, a tab wire arranged on a surface electrode thereof, a conductive adhesive film arranged therebetween, and a sheet of sealing resin which covers the entire surface of the thin-film solar cell. The operation of Figs. 2A to 2E can be performed to perform a tab wire connection step and a resin sealing step at a time.

The decompression laminator used in the present invention has been described above. The decompression laminator is not limited to one that is composed of the upper unit 11 and the lower unit 12 as shown in Fig. 1. A decompression laminator configured so that the interior of a single casing is partitioned into two chambers and a door is opened and closed to load and unload a laminate may be used. The first chamber and the second chamber may be such that compressed air is let into the first chamber for pressurization up to or above the atmospheric pressure. The second chamber may be configured so that the air inside the chamber is simply let out without decompression.

Next, using the decompression laminator described above, an aspect of the manufacturing method according to the present invention will be described with reference to the drawings.

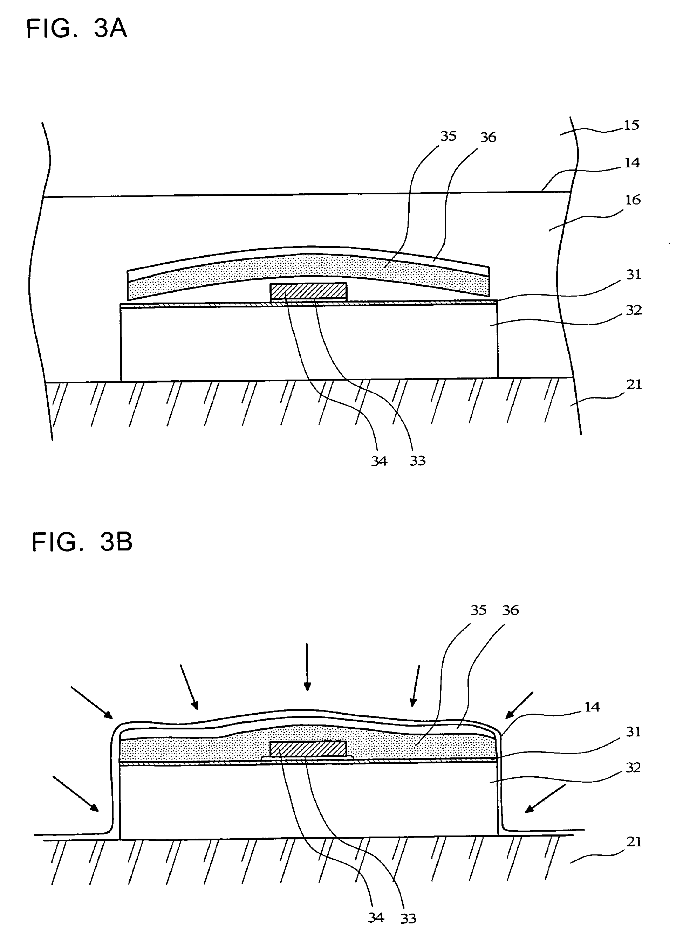

Initially, as shown in Fig. 3A (a partial enlarged view of the decompression laminator), a thin-film solar cell 32 having a surface electrode 31 is placed on the heating stage 21 in the second chamber 16 of the decompression laminator which is partitioned from the first chamber 15 by the flexible sheet 14. A conductive adhesive film 33 is stacked on the surface electrode 31, a tab wire 34 on the conductive adhesive film 33, a sealing resin sheet 35 on the tab wire 34, and a moisture-proof back sheet 36 or a glass plate (not shown) on the sealing resin sheet 35 in order.

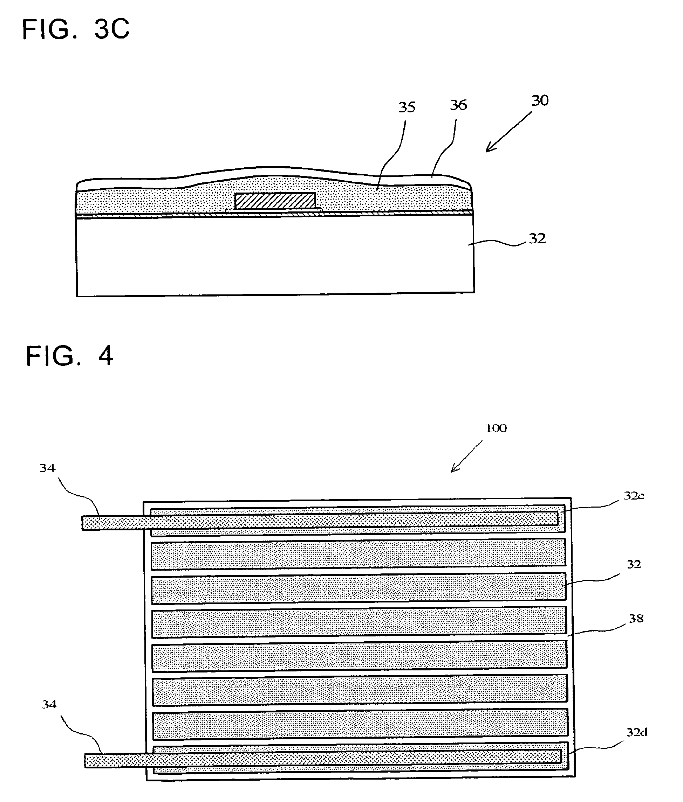

Next, as shown in Fig. 3B, the internal pressure of the first chamber of the decompression laminator is made relatively higher than that of the second chamber so that the flexible sheet 14 presses the moisture-proof back sheet 36 or glass plate while the heating stage 21 heats the thin-film solar cell 32. As a result, the surface electrode 31 of the thin-film solar cell 32 and the tab wire 34 are connected with the conductive adhesive film 33, and the thin-film solar cell 32 is resin-sealed with the sealing resin sheet 35. A thin-film solar cell module 30 is thus obtained (Fig. 3C).

Preferred operations for making the internal pressure of the first chamber 15 relatively higher than that of the second chamber 16 of the decompression laminator include bringing both the internal pressures of the first chamber 15 and the second chamber 16 into a decompressed state before opening the first chamber 15 to the air with the second chamber 16 maintained in the decompressed state.

The conductive adhesive film 33 is a film-like molded article of thermoplastic resin in which conductive particles are dispersed. Publicly known conductive adhesive films used to mount electronic parts on a solar cell may be used. In the present invention, a conductive adhesive film is preferably selected in view of the relationship with the sealing resin sheet 35 in order to provide the effects of the present invention.

For example, in the present invention, the thermoplastic resin that constitutes the conductive adhesive film 33 and the sealing resin that constitutes the sealing resin sheet 35 need to be compatible with each other. The reason is that the mutual compatibility enables favorable void-free resin sealing, and intended characteristics (such as adhesion strength and moisture resistance) can be obtained without mixing a curing agent into the sealing resin.

If the thermoplastic resin constituting the conductive adhesive film 33 has too low a melt viscosity (B type viscometer, 220°C), it becomes difficult to maintain the film form and the heat resistance drops. Too high a melt viscosity lowers the compatibility with the sealing resin and increases connection resistance. The melt viscosity is preferably 1.0 × 10² to 1.0 × 10⁵ Pa.s, and more preferably 1.0 × 10³ to 1.0 × 10⁵ Pa.s. The melt viscosity is preferably lower than that of the sealing resin constituting the sealing resin sheet 35 so that the conductive adhesive film melts more easily than the sealing resin sheet in connection areas. Here, if the difference in melt viscosity between the two resins is too small, the conductive adhesive film itself fails to melt sufficiently and the connection resistance increases. Too large a difference lowers the adhesion force of the conductive adhesive film itself. The difference is preferably 1.0 × 10² to 1.0 × 10⁵ Pa·s, and more preferably 1.0 × 10³ to 1.0 × 10⁵ Pa·s .

The thermoplastic resin constituting the conductive adhesive film 33 and the sealing resin constituting the sealing resin sheet 35 may be independently selected as appropriate from a large number of thermoplastic resins in consideration of compatibility, melt viscosity, etc. As resins having favorable adhesion force with high hydrolysis resistance and high flame resistance, polyurethane resins are preferably used instead of EVA resins that have conventionally been used. In particular, for such polyurethane resins, a blended polymer is preferably used that contains a thermoplastic polyurethane resin having ester type polyol units (hereinafter, may be referred to as an ester polyol polyurethane) which have relatively high adhesion force and are easily hydrolyzable, and a thermoplastic polyurethane resin having ether type polyol units (hereinafter, may be referred to as an ether polyol polyurethane) which have relatively low adhesion force and are less hydrolyzable. Such a blended polymer strongly reflects favorable characteristics (i.e., favorable adhesiveness and high hydrolysis resistance) and less unfavorable characteristics, and has favorable flame resistance as well.

The ester polyol polyurethane and ether polyol polyurethane in the blended polymer have a blend mass ratio of 10:90 to 50:50, and preferably 10:90 to 30:70. If the former is too small in amount, the resulting adhesive force weakens. If the former is too large in amount, easy hydrolysis facilitates erosion of the surface electrode, and the lowering adhesive force is likely to occur.

The thermoplastic resin constituting the conductive adhesive film 33 and the sealing resin constituting the sealing resin sheet 35 may contain other thermoplastic resins, silane coupling agents, cross-liking agents, antioxidants, and the like if needed. In particular, the thermoplastic resin constituting the conductive adhesive film 33 is preferably mixed with a tackifier such as a petroleum-based tackifier. This can make the conductive adhesive film melt more easily than the sealing resin sheet, and can improve the connection reliability of the conductive adhesive film 33.

The conductive particles constituting the conductive adhesive film 33 may be conductive particles used in publicly known conductive adhesive films (CF) that are used when mounting electronic parts on a solar cell. Examples thereof may include amorphous, spherical, and flaky conductive particles of carbon, gold, copper, solder, and nickel, and metal coated resin particles. The surfaces of metal particles other than gold may be gold-plated. Of these, flaky nickel particles may be suitably used in view of procurement cost, connection reliability, etc.

If the average particle diameter of the conductive particles is too small, small contact areas increase connection resistance. Too large an average particle diameter lowers the volume percent of the thermoplastic resin in the conductive adhesive film and causes an initial adhesion failure. Preferred average particle diameters are 2 to 50 µm, and more preferably 5 to 40 µm.

A typical mixing ratio of the conductive particles and the thermoplastic resin in the conductive adhesive film 33 is 1:5 to 1:15 parts by mass.

If the conductive adhesive film 33 has too small a thickness, an initial adhesion failure occurs. Too large a thickness increases connection resistance. Preferred thicknesses are 15 to 30 µm, and more preferably 15 to 20 µm.

The average particle diameter of the conductive particles, the mixing ratio of the conductive particles and the thermoplastic resin, and the like can be appropriately selected to give the conductive adhesive film 33 anisotropic conductivity.

In order to interrupt a current that flows between electrodes when the solar cell module is overheated, the conductive adhesive film 33 according to the present invention may contain materials that exhibit current interrupting power when overheated. Examples thereof may include aluminum hydroxide particles, hollow solder particles, and high-temperature expansive microcapsules. Of these, high-temperature expansive microcapsules are preferably mixed since the interruption temperature can be selected.

Such materials have respective different mechanisms for current interruption. For example, aluminum hydroxide particles cause a dehydration reaction to produce aluminum oxide and water when heated to 200°C to 300°C. The produced water expands further to form voids, which interrupt conduction between electrodes that are opposed with the conductive adhesive film therebetween. Hollow solder particles, which can also be used as conductive particles, include various types having different melting temperatures. When overheated to or above such melting temperatures (typically 180°C to 250°C), hollow solder particles melt and deform, thereby interrupting conduction between electrodes that are opposed with the conductive adhesive film therebetween. When high-temperature expansive microcapsules are overheated, the microcapsules expand to interrupt conduction between electrodes that are opposed with the conductive adhesive film therebetween.

Aluminum hydroxide particles having a particle diameter of 3 to 5 µm can be suitably used. If aluminum hydroxide particles mixed in the conductive adhesive film 33 are too small in amount, the current interrupting effect is not sufficient. Too large an amount causes a conduction failure. The amount of aluminum hydroxide particles is preferably 2 to 10 parts by mass based on 100 parts by mass of the thermoplastic resin, and more preferably 5 to 7 parts by mass.

Hollow solder particles having a particle diameter of 10 to 15 µm can be suitably used. The solder particles preferably have a hollow diameter of 5 to 7 µm. Such hollow solder particles can be prepared by publicly known techniques. If hollow solder particles mixed in the conductive adhesive film 33 are too small in amount, the conduction performance is not sufficient. Too large an amount makes the current interrupting effect insufficient. The amount of hollow solder particles is preferably 5 to 15 parts by mass based on 100 parts by mass of the thermoplastic resin, and more preferably 10 to 15 parts by mass.

High-temperature expansive microcapsules are spherical particles of a foaming agent (for example, low-boiling hydrocarbon such as hexane and octane) coated with a thermoplastic resin such as an acrylonitrile-based polymer. The microcapsules preferably have a particle diameter of 30 to 40 µm, a film thickness of 2 to 15 µm, and an expansion ratio of 50 to 100 times. Concrete examples of such high-temperature expansive microcapsules may include: Matsumoto Microsphere F series (F-170, F-190D, and F-230D) from Matsumoto Yushi-Seiyaku Co., Ltd.; Daifoam V series (V307 and V-308) from Dainichiseika Color & Chemicals Mfg. Co., Ltd.; and KUREHA Microsphere series from Kureha Corporation. If high-temperature expansive microcapsules mixed in the conductive adhesive film 33 are too small in amount, the current interrupting effect is insufficient. Too large an amount can cause an initial adhesion failure. The amount of high-temperature expansive microcapsules is preferably 2 to 7 parts by mass based on 100 parts by mass of the thermoplastic resin, and more preferably 3 to 5 parts by mass.

The tab wire 34 used in the manufacturing method of the present invention is one that is used as an outer lead of a surface electrode of a thin-film solar cell in a conventional thin-film solar cell module. A metal foil strip, and preferably a copper foil strip, may be used. In particular, in the present invention, a tab wire 34 having a surface roughness (Rz (JIS B0601-2001)) of 5 to 15 µm on the conductive adhesive film side is preferably used, and more preferably 10 to 15 µm. This can improve the adhesion of the conductive adhesive film 33 to the tab wire 34, with an effect of reducing connection resistance. Surface roughness below the range increases connection resistance. Surface roughness above the range tends to cause an initial adhesion failure.
The surface roughness of the tab wire 34 can be adjusted by publicly known techniques, including sandblasting and soft etching using chemical abrasives.

The conductive adhesive film 33 and the tab wire 34 used in the manufacturing method of the present invention may be integrated in advance according to the ordinary method. This can simplify operations when using a vacuum laminator. The integration can be performed by applying conductive adhesive paint to copper foil, drying the same, and hardening the same if needed.

According to the manufacturing method of the present invention, the moisture-proof back sheet 36 or glass plate is stacked on the sealing resin sheet 35. A sheet or plate used in conventional known thin-film solar cell modules may be appropriately selected for use. The sealing resin sheet 35 and the moisture-proof back sheet 36 or glass plate may be integrated in advance. This can simplify operations when using a vacuum laminator. The integration can be performed by applying a sealing resin solution to the moisture-proof back sheet 36 or glass plate, and drying the same.

Examples of the thin-film solar cell 32 having a surface electrode 31 include a thin-film solar cell that uses a thin-film photoelectric conversion element which needs the bonding of a tab wire 34 and resin sealing. Conventional known materials may be used as the materials of the photoelectric conversion element of a thin-film solar cell. Examples thereof may include amorphous silicon.

Up to this point, a method of manufacturing a solar cell module, including connecting a tab wire to one side of a thin-film solar cell and performing resin sealing at a time, has been described in detail. However, the present invention is not limited thereto. For example, as shown in Fig. 4, the present invention also covers connecting power-output tabs to photoelectric conversion elements at both ends of a solar cell module and resin-sealing the same, the solar cell module including long thin-film photoelectric conversion elements directly connected sideways (see Figs. 3 and 4 of Japanese Patent Application Laid-Open No. 2000-340811).

In such a case, the thin-film solar cells 32 composed of thin-film photoelectric conversion elements are arranged in series in a planar direction on a base 38. Power-output tab wires 34 are temporarily bonded to a surface electrode (not shown) of the thin-film solar cell 32c at one end and a surface electrode (not shown) of the thin-film solar cell 32d at the other end by pressurization at ambient temperatures or by pressurization at low temperatures (approximately 30°C to 120°C) via a conductive adhesive film. This produces a thin-film solar cell unit 100. The thin-film solar cell 32 of Figs. 3A to 3C can be replaced with such a thin-film solar cell unit 100 to form a thin-film solar cell module out of a plurality of thin-film solar cells. In that case, the surface electrodes at both ends and the power-output tab wires can be connected at a time.

### Examples

The present invention will be described in more detail below in conjunction with embodiments.

### Reference Examples 1 to 3 (sealing resin sheets) and Reference Examples 4 to 6 (conductive adhesive films)

In Reference Examples 1 to 3, the components of the compositions of Table 1 were melted and mixed. The mixtures were extruded to manufacture 0.5-mm-thick sealing resin sheets. In Reference Examples 4 and 5, the components of the compositions of Table 1 were mixed, and toluene was further added to adjust the solid content concentration to 30%. Using a roll coater, the mixtures were applied to a release agent-treated polyester base so as to have a dry thickness of 25 µm. The resultant were dried in an oven of 80°C to manufacture conductive adhesive films.

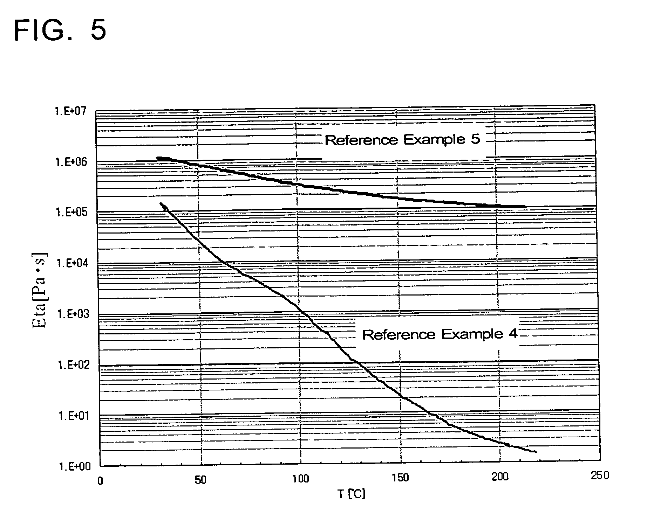

Fig. 5 shows the temperature-viscosity characteristics of the conductive adhesive films according to Reference Examples 4 and 5. From Fig. 5, it can be seen that the melt viscosity decreases if a tackifier is mixed in.

**[Table 1]**

| | Reference Example (Sealing resin sheet) | | | Reference Example (Conductive adhesive film) | | |
|---|---|---|---|---|---|---|
| | 1 | 2 | 3 | 4 | 5 | 6 |
| Ester polyol polyurethane ^{*1} | 30 | 10 | 50 | 30 | 30 | 30 |
| Ether polyol polyurethane A ^{*2} | 30 | 30 | 30 | 40 | 40 | 40 |
| Ether polyol polyurethane B ^{*3} | 40 | 60 | 20 | 30 | 30 | 30 |
| ^{*4} Coloring material | 2 | 2 | 2 | 2 | 2 | 2 |
| Weatherization agent ^{*5} | 5 | 5 | 5 | 5 | 5 | 5 |
| Hydrolysis resistant agent ^{*6} | 5 | 5 | 5 | 5 | 5 | 5 |
| Isocyanate type coupling agent ^{*7} | 0.5 | 0.5 | 0.5 | 0.5 | 0.5 | 0.5 |
| Petroleum-based tackifier ^{*8} | - | - | - | 40 | - | 40 |
| High-temperature expansive microcapsules ^{*9} | - | - | - | - | - | 5 |
| Conductive particles ^{*10} | - | - | - | 15 | 15 | 15 |

| | | | | | | |
|---|---|---|---|---|---|---|
| Notes in Table 1: *1: Elastollan ETHD95A, BASF Japan Ltd. *2: Elastollan 1175A-10W, BASF Japan Ltd. *3: Elastollan ET370, BASF Japan Ltd. *4: Black 880 M50, BASF Japan Ltd. *5: UNE, BASF Japan Ltd. *6: KE 9463, Rhein Chemie Japan Ltd. *7: KBE 9007, Shin-Etsu Chemical Co., Ltd. *8: Arkon P125, Arakawa Chemical Industries, Ltd. *9: F190D, Matsumoto Yushi-Seiyaku Co., Ltd. *10: (particles specified by Examples and Comparative Examples to be described below) | | | | | | |

### Examples 1 to 10

Thin-film solar cell test modules were made as described below by using sealing resin sheets and conductive adhesive films shown in Table 2. A glass plate of 30 mm in width, 80 mm in length, and 0.7 mm in thickness, having 2.0-mm-width Ag electrodes, Al electrodes, or ITO electrodes of line shape at a pitch of 2.0 mm, was used instead of a thin-film solar cell. In addition, Cu wires (2-mm-width × 0.15-mm-thick) having a surface roughness Rz (JIS B0601-2001) of 10 µm were used as tab wires. A 75-µm-thick polyethylene terephthalate film (X10S, Toray Industries, Inc.) was used as a moisture-proof back sheet.

More specifically, a glass substrate was placed on the heating stage in the second chamber of the decompression laminator of Fig. 1. A conductive adhesive film (2 mm in width, 5 mm in length, and 0.05 mm in thickness) without a polyester base was placed on the surface. A tab wire was stacked thereon. A pressing film, a sealing resin sheet, and a moisture-proof back sheet were further stacked. With the stage maintained at 150°C, both the first chamber and the second chamber were decompressed to 133 Pa. The second chamber was then kept decompressed while air was let into the first chamber up to the atmospheric pressure. Such a state was maintained for five minutes before air was let into the second chamber up to the atmospheric pressure. A thin-film solar cell test module was thus obtained. Tab wire connection and resin sealing were successfully performed at a time at the relatively low process temperature of the resin sealing step.

### Comparative Example 1

A 30 mm × 80 mm × 0.5 mm of ethylene-vinyl acetate copolymer sheet (PVC-TG, Sekisui Chemical Co., Ltd.) was used as a sealing resin sheet. In other respects, the operation of Example 1 was repeated to obtain a thin-film solar cell module for comparison.

### <Evaluations>

To evaluate the long-term reliability of a thin-film solar cell module and the sealing power and adhesion of the sealing resin sheet in the thin-film solar cell module at the same time, the thin-film solar cell modules were stored in an environment of 85°C and 85% RH for 1000 hours, and measured for a resistance across adjoining electrodes. Based on the measurements, the connection reliability of the thin-film solar cell modules was numerically rated based on the criteria described below. Table 2 shows the results. The higher the score, the more favorable the connection reliability.

### Score Criteria

5 Resistance is lower than 0.03 Ω
4 Resistance is higher than or equal to 0.03 Ω and lower than 0.1 Ω
3 Resistance is higher than or equal to 0.1 Ω and lower than 0.3 Ω
2 Resistance is higher than or equal to 0.3 Ω and lower than 1.0 Ω
1 Resistance is 1.0 Ω or higher

### Overall evaluation

For connection reliability, a total score of 14 or higher was evaluated as "AAA." A total score of 11 to 13 was evaluated as "AA," 9 to 10 as "A," 6 to 8 as "B," and 5 or less as "C." For practical purposes, "AAA," "AA," "A," or "B" is desired.

**[Table 2]**

| | Sealing resin sheet | Conductive adhesive film | Conductive particles | Plating layer (Type) | Particle diameter (µm) | Connection reliability (to electrode) | | | | Overall evaluation |
|---|---|---|---|---|---|---|---|---|---|---|
| | | | | | | Ag | Al | rro | Total | |
| Comparative Example 1 | EVA sheet | Reference Example4 | Flaky Ni ^{*11} | - | < 40 | 1 | 1 | 1 | 3 | C |
| Example 1 | Reference Example 1 | Reference Example 4 | Flaky Ni ^{*11} | - | <40 | 5 | 4 | 5 | 14 | AAA |
| Example 2 | Reference Example 2 | Reference Example 4 | Flaky Ni ^{*11} | - | <40 | 4 | 4 | 4 | 12 | AA |
| Example 3 | Reference Example 3 | Reference Example 4 | Flaky Ni^{*11} | - | <40 | 4 | 3 | 3 | 10 | A |
| Example 4 | Reference Example 1 | Reference Example 5 | Flaky Ni ^{*11} | - | <40 | 4 | 4 | 4 | 12 | AA |
| Example 5 | Reference Example 1 | Reference Example 5 | Spherical Ni ^{*12} | Au | 5 | 5 | 3 | 5 | 13 | AA |
| Example 6 | Reference Example 1 | Reference Example 5 | Metal-coated spherical resin ^{*13} | Au | 10 | 5 | 3 | 5 | 13 | AA |
| Example 7 | Reference Example 1 | Reference Example 4 | Amorphous Ni ^{*14} | - | 2 | 2 | 3 | 2 | 7 | B |
| Example 8 | Reference Example 1 | Reference Example 4 | Spherical Ni ^{*15} | - | 5 | 2 | 2 | 3 | 7 | B |
| Example 9 | Reference Example 1 | Reference Example 4 | Spherical Ni ^{*16} | - | 10 | 2 | 2 | 4 | 8 | B |
| Example 10 | Reference Example 1 | Reference Example 6 | Flaky Ni ^{*11} | - | <40 | 5 | 4 | 5 | 14 | AAA |

| | | | | | | | | | | |
|---|---|---|---|---|---|---|---|---|---|---|
| Notes in Table 2: *11: HCA-1, Novamet Inc. *12: Nickel powder (type 255, Vale Inco Limited) classified to an average particle diameter of 5 µm, followed by gold plating on the nickel surface by displacement plating. *13: Conductive particles (AUE-10µm, Sekisui Chemical Co., Ltd.) *14: Nickel powder (type 255, Vale Inco Limited) *15: Nickel powder (type 255, Vale Inco Limited) classified to an average particle diameter of 5 µm *16: Nickel powder (type 255, Vale Inco Limited) classified to an average particle diameter of 10 µm | | | | | | | | | | |

As can be seen from Table 2, Comparative Example 1, which combines a sealing resin sheet and a conductive adhesive film not compatible with each other, had an overall evaluation of C and was practically unusable. Examples 1 to 10, which combine a sealing resin sheet and a conductive adhesive film compatible with each other, had overall evaluations of AAA, AA, A or B and were practically usable. The results show that according to the manufacturing method of the present invention, connection strength more than from the width of a tab wire was provided. Sealing power was also improved to successfully improve the long-term reliability of the solar cell characteristics.

From the results of Examples 1 to 10, it can be seen that flaky Ni is preferably used as conductive particles. The results of Examples 5 and 6 show that the Au plating on conductive particles is effective at improving connection reliability. In particular, Example 1 provided the most favorable connection reliability since the conductive adhesive film melts more easily than the sealing resin sheet and flaky Ni is used as the conductive particles. The thin-film solar cell modules of Examples 1 and 10 had particularly superior connection reliability.

A sample of the thin-film solar cell module of Example 10 was stored in an environment of 85°C and 85% RH for 1000 hours. The sample was heated at 250°C for 60 sec, and then measured for a resistance between adjoining electrodes at room temperature. The measurement showed an open resistance. This confirms that if a conductive adhesive film containing heat expansive microcapsules is used to establish connection between electrodes of a thin-film solar cell module, a current flowing between the electrodes can be interrupted when the thin-film solar cell module is overheated.

### Industrial Applicability

According to the method of manufacturing a solar cell module of the present invention, when a tab wire is connected to the surface electrode of a thin-film solar cell with a conductive adhesive film made of thermoplastic resin in which conductive particles are dispersed, the thermoplastic resin of the conductive adhesive film and a sealing resin melt together. A tab wire connecting step and a resin sealing step can thus be performed at a time at a relatively low process temperature of the resin sealing step. In addition, connection strength more than from the width of the tab wire can be obtained, and sealing power improves. This improves the long-term reliability of solar cell characteristics. The manufacturing method of the present invention is thus useful in manufacturing a solar cell module having excellent long-term reliability.

### Reference Signs List

- 10: decompression laminator
- 11: upper unit
- 12: lower unit
- 13: seal member
- 14: flexile sheet
- 15: first chamber
- 16: second chamber
- 17, 17a, 17b, 18, 18a, 18b: piping
- 19, 20: changeover valve
- 30: thin-film solar cell module
- 31: surface electrode
- 32, 32a, 32b, 32c, 32d: thin-film solar cell
- 33: conductive adhesive film
- 34: tab wire
- 35: sealing resin sheet
- 36: moisture-proof back sheet
- 100: thin-film solar cell unit

## Claims

1. A method of manufacturing a thin-film solar cell module by using a decompression laminator, the thin-film solar cell module having a structure such that a thin-film solar cell having a surface electrode to which a tab wire is connected with a conductive adhesive film is resin-sealed with a sealing resin, the conductive adhesive film being made of a thermoplastic resin in which conductive particles are dispersed, the method including:
using, as the sealing resin, a resin mutually compatible with the thermoplastic resin constituting the conductive adhesive film;
using, as the decompression laminator, one having a first chamber and a second chamber partitioned by a flexible sheet, the first and second chambers each being capable of independent internal pressure adjustment, the second chamber including a heating stage capable of heating;
placing a solar cell having a surface electrode upon the heating stage of the second chamber of the decompression laminator, arranging the conductive adhesive film and the tab wire on the surface electrode in succession, further arranging a sheet-like sealing resin so as to cover the entire solar cell, and arranging a moisture-proof back sheet or glass plate thereon; and
making the internal pressure of the first chamber of the decompression laminator relatively higher than that of the second chamber so that the flexible sheet presses the moisture-proof back sheet or glass plate while the heating stage heats the solar cell, whereby the surface electrode of the thin-film solar cell and the tab wire are connected with the conductive adhesive film and the thin-film solar cell is resin-sealed with the sealing resin to obtain a solar cell module.

2. The method of manufacturing according to claim 1, wherein an operation for making the internal pressure of the first chamber of the decompression laminator relatively higher than that of the second chamber includes bringing both the internal pressures of the first chamber and the second chamber into a decompressed state before opening the first chamber to the air with the second chamber maintained in the decompressed state.

3. The method of manufacturing according to claim 1 or 2, wherein the thermoplastic resin constituting the conductive adhesive film has a melt viscosity lower than that of the sealing resin.

4. The method of manufacturing according to any of claims 1 to 3, wherein the thermoplastic resin and the sealing resin are each a polyurethane resin.

5. The method of manufacturing according to claim 4, wherein the polyurethane resin is a blended polymer containing ester polyol polyurethane and ether polyol polyurethane in a mass ratio of 10:90 to 30:70.

6. The method of manufacturing according to any of claims 1 to 5, wherein the tab wire has a surface roughness (Rz) of 5 to 15 µm on the conductive adhesive film side.

7. The method of manufacturing according to any of claims 1 to 6, wherein the conductive adhesive film and the tab wire are integrated in advance.

8. The method of manufacturing according to any of claims 1 to 6, wherein the sealing resin and the moisture-proof back sheet or glass plate are integrated in advance.

9. The method of manufacturing according to any of claims 1 to 8, wherein a plurality of thin-film solar cells are connected in series.

10. The method of manufacturing according to any of claims 1 to 9, wherein the conductive adhesive film further contains high-temperature expansive microcapsules.

11. A solar cell module manufactured by the method of manufacturing according to any of claims 1 to 10.
